# EUROPEAN PATENT APPLICATION

(11) **EP 4 827 260 A1**
(43) Date of publication of application: **21.10.2026**
(21) Application number: 25887805.7
(22) Date of filing: 15.08.2025
(51) Int. Cl.: H10B 12/00

(54) **SEMICONDUCTOR STRUCTURE AND FABRICATION METHOD THEREFOR, AND ELECTRONIC DEVICE**

(30) Priority: 08.11.2024 CN 202411596586
(71) Applicant: CXMT Corporation, Hefei City, Anhui Province 230601 (CN)
(72) Inventor: XUE, Xingkun, Hefei, Anhui 230601 (CN); LIU, Jinying, Hefei, Anhui 230601 (CN); MA, Di, Hefei, Anhui 230601 (CN); QIU, Yunsong, Hefei, Anhui 230601 (CN)
(74) Representative: Gulde & Partner
(86) International application number: PCT/CN2025/114925
(87) International publication number: WO 2026/097995

(57) **Abstract**

Disclosed are a semiconductor structure, a manufacturing method therefor, and an electronic device. The semiconductor structure includes an active pillar extending in a vertical direction; a word line extending in a first horizontal direction and coupled to the active pillar to form a transistor; and a bit line extending in a second horizontal direction and coupled to the active pillar. The second horizontal direction intersects the first horizontal direction. The word line includes a first conductive pattern and a second conductive pattern. The first conductive pattern has a first opening and a second opening arranged alternately in the first horizontal direction. The active pillar is located in the first opening. The second conductive pattern is located in the second opening. The resistivity of the second conductive pattern is less than the resistivity of the first conductive pattern. The semiconductor structure helps reduce the resistance of the word line and improve device performance.

## Description

This application claims priority to Chinese Patent Application No. 202411596586.2, filed with the China National Intellectual Property Administration on November 08, 2024 and entitled "SEMICONDUCTOR STRUCTURE, MANUFACTURING METHOD THEREFOR, AND ELECTRONIC DEVICE", which is incorporated herein by reference in its entirety.

### TECHNICAL FIELD

Embodiments of the present disclosure relate to the field of semiconductor technologies, and in particular, to a semiconductor structure, a manufacturing method therefor, and an electronic device.

### BACKGROUND

A dynamic random access memory (Dynamic Random Access Memory, DRAM) is a semiconductor memory. Compared with a static memory, the DRAM has advantages such as a simple structure, low manufacturing costs, and high storage density. With the development of technologies, the DRAM has found increasingly widespread applications. The dynamic random access memory (DRAM) includes multiple storage units, and each storage unit includes a transistor and a capacitor coupled to the transistor. One of the source and drain of the transistor is connected to a bit line, the other of the source and drain of the transistor is connected to the capacitor, and the gate of the transistor is connected to a word line. Under control of the word line, the transistor stores data information in the capacitor or reads data information from the capacitor through the bit line.

With the development of semiconductor technologies, an architecture solution is provided for changing a planar transistor or a buried transistor in the DRAM to a vertical transistor (whose channel extends at least partially in the vertical direction). In this architecture, a vertically extending active pillar is formed on a substrate, and a gate is formed on a sidewall of the active pillar.

### SUMMARY

According to a first aspect of the embodiments of the present disclosure, a semiconductor structure is provided, including an active pillar, extending in a vertical direction; a word line, extending in a first horizontal direction and coupled to the active pillar to form a transistor; and a bit line, extending in a second horizontal direction and coupled to the active pillar. The second horizontal direction intersects the first horizontal direction. The word line includes a first conductive pattern and a second conductive pattern connected to each other. The first conductive pattern has a first hole and a second hole arranged alternately in the first horizontal direction. The active pillar is located in the first hole. The second conductive pattern is located in the second hole. The resistivity of the second conductive pattern is less than the resistivity of the first conductive pattern.

In some embodiments, the first hole is surrounded by a first extension portion and a second extension portion of the first conductive pattern, the first extension portion extends in the first horizontal direction, the second extension portion extends in the second horizontal direction, and the width of the second extension portion is greater than 1/2 of the width of the first extension portion.

In some embodiments, the width of the second extension portion is less than the width of the first extension portion.

In some embodiments, the second hole is surrounded by the second extension portion and a third extension portion of the first conductive pattern, the third extension portion extends in the first horizontal direction, and the width of the third extension portion is equal to the width of the second extension portion.

In some embodiments, the first hole is a via, and the second hole is a via.

In some embodiments, the first hole is a via, and the second hole is a blind via.

In some embodiments, the gap-fill ability of the material of the first conductive pattern is stronger than the gap-fill ability of the material of the second conductive pattern.

In some embodiments, the material of the first conductive pattern includes titanium nitride, and the material of the second conductive pattern includes molybdenum or tungsten.

In some embodiments, the semiconductor structure further includes: a data storage element, coupled to the transistor.

According to a second aspect of the embodiments of the present disclosure, a manufacturing method for a semiconductor structure is provided, including: a semiconductor substrate is provided; the semiconductor substrate is etched to form an active pillar extending in a vertical direction; a word line is formed, where the word line extends in a first horizontal direction and is coupled to the active pillar; and a bit line is formed, where the bit line extends in a second horizontal direction and is coupled to the active pillar. The second horizontal direction intersects the first horizontal direction. The word line includes a first conductive pattern and a second conductive pattern. The first conductive pattern has a first hole and a second hole arranged alternately in the first horizontal direction. The active pillar is located in the first hole. The second conductive pattern is located in the second hole. The resistivity of the second conductive pattern is less than the resistivity of the first conductive pattern.

In some embodiments, the first hole is surrounded by a first extension portion and a second extension portion of the first conductive pattern, the first extension portion extends in the first horizontal direction, the second extension portion extends in the second horizontal direction, and the width of the second extension portion is greater than 1/2 of the width of the first extension portion.

In some embodiments, the width of the second extension portion is less than the width of the first extension portion.

In some embodiments, the second hole is surrounded by the second extension portion and a third extension portion of the first conductive pattern, the third extension portion extends in the first horizontal direction, and the width of the third extension portion is equal to the width of the second extension portion.

In some embodiments, the first hole is a via, and the second hole is a via.

In some embodiments, the first hole is a via, and the second hole is a blind via.

In some embodiments, the gap-fill ability of the material of the first conductive pattern is stronger than the gap-fill ability of the material of the second conductive pattern.

In some embodiments, the material of the first conductive pattern includes titanium nitride, and the material of the second conductive pattern includes molybdenum or tungsten.

In some embodiments, the manufacturing method further includes the following: a data storage element is formed, where the data storage element is coupled to the active pillar.

According to a third aspect of embodiments of the present disclosure, an electronic device is provided, including a processor and the memory provided in any embodiment of the present disclosure. The memory is coupled to the processor.

In the semiconductor structure provided in the embodiments of the present disclosure, the word line includes the first conductive pattern with a larger resistivity and the second conductive pattern with a smaller resistivity, thereby helping reduce the resistance of the word line and improve device performance.

### BRIEF DESCRIPTION OF DRAWINGS

FIG. 1A is a schematic diagram of a partial planar structure of a semiconductor structure according to some embodiments of the present disclosure;
FIG. 1B is a schematic diagram of a planar structure of a first conductive pattern in a word line of a semiconductor structure according to some embodiments of the present disclosure;
FIG. 1C is a schematic diagram of a partial cross-sectional structure taken along a line A1-A2 in FIG. 1A according to some embodiments of the present disclosure;
FIG. 1D is a schematic diagram of another partial cross-sectional structure taken along a line A1-A2 in FIG. 1A according to some embodiments of the present disclosure;
FIG. 1E is a schematic diagram of a partial cross-sectional structure taken along a line B1-B2 in FIG. 1A according to some embodiments of the present disclosure;
FIG. 2 is a schematic flowchart of a manufacturing method for a semiconductor structure according to some embodiments of the present disclosure;
FIG. 3A to FIG. 3D are schematic diagrams of a cross-sectional structure at some stages of a manufacturing method for a semiconductor structure according to some embodiments of the present disclosure;
FIG. 4 is a schematic block diagram of a structure of an electronic device according to some embodiments of the present disclosure.

### DESCRIPTION OF EMBODIMENTS

The technical solutions of the present disclosure are further described below in detail with reference to the accompanying drawings and the embodiments. Although example implementation methods of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not drawn to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily describe a specific order or sequence.

In the embodiments of the present disclosure, the term "layer" refers to a material part including a region having the thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. The layer may include multiple sublayers.

In the embodiments of the present disclosure, the term "coupling" refers to two (or more) conductive structures being operatively connected to each other, which, according to an actual need, may include but is not limited to the following cases: (1) The two conductive structures are directly electrically connected; (2) the two conductive structures are indirectly electrically connected (through another conductive structure); (3) although the two conductive structures are not electrically connected (e.g., an insulating layer is disposed therebetween), but one of the two conductive structures may control electrical performance of the other conductive structure in response to an electrical signal, e.g., a gate (or a word line) is coupled to an active region (or a channel region).

It should be noted that the technical solutions and the technical features described in the embodiments of the present disclosure may be randomly combined when there is no conflict.

At least some embodiments of the present disclosure provide a semiconductor structure. The semiconductor structure includes an active pillar, extending in a vertical direction; a word line, extending in a first horizontal direction and coupled to the active pillar to form a transistor; and a bit line, extending in a second horizontal direction and coupled to the active pillar. The second horizontal direction intersects the first horizontal direction. The word line includes a first conductive pattern and a second conductive pattern. The first conductive pattern has a first hole and a second hole arranged alternately in the first horizontal direction. The active pillar is located in the first hole. The second conductive pattern is located in the second hole. The resistivity of the second conductive pattern is less than the resistivity of the first conductive pattern.

In the semiconductor structure provided in the embodiments of the present disclosure, the word line includes the first conductive pattern with a larger resistivity and the second conductive pattern with a smaller resistivity, thereby helping reduce the resistance of the word line and improve device performance.

The following describes in detail the semiconductor structure provided in the embodiments of the present disclosure with reference to the accompanying drawings.

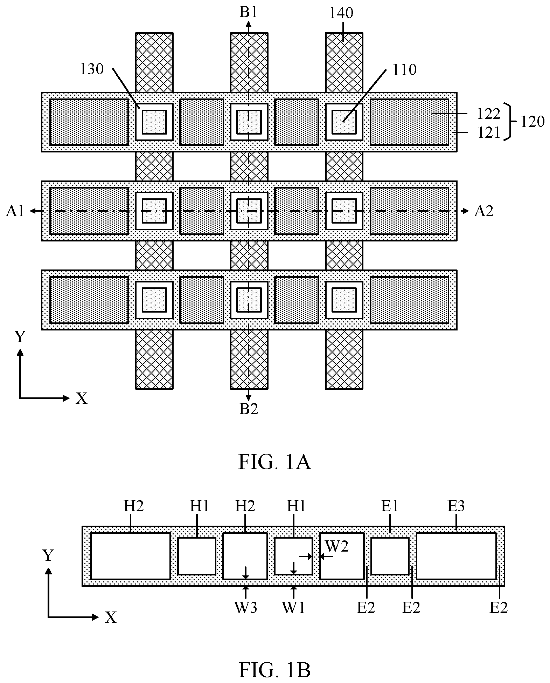

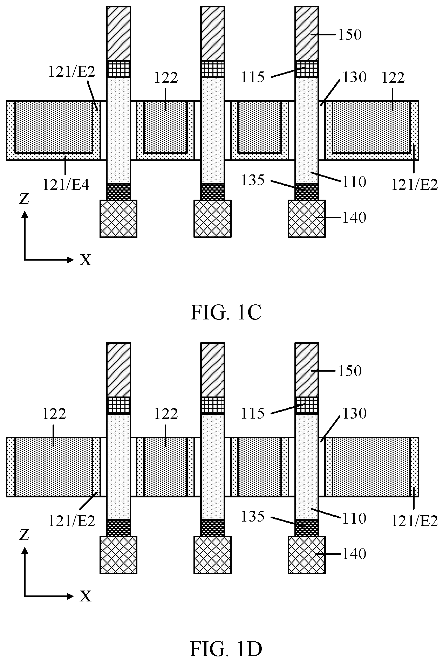

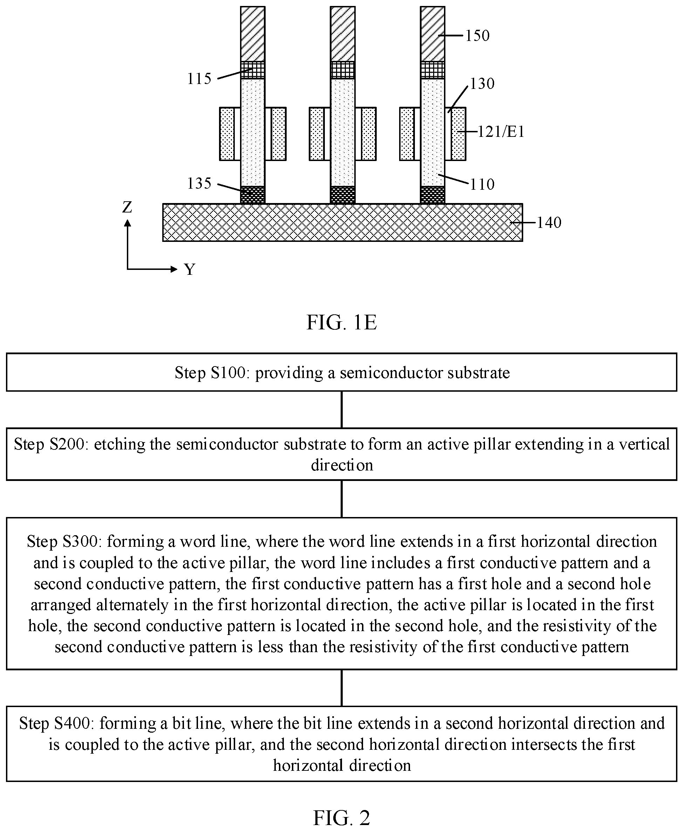

FIG. 1A is a schematic diagram of a partial planar structure of a semiconductor structure according to some embodiments of the present disclosure. FIG. 1B is a schematic diagram of a planar structure of a first conductive pattern in a word line of a semiconductor structure according to some embodiments of the present disclosure. FIG. 1C is a schematic diagram of a partial cross-sectional structure taken along a line A1-A2 in FIG. 1A according to some embodiments of the present disclosure. FIG. 1D is a schematic diagram of another partial cross-sectional structure taken along a line A1-A2 in FIG. 1A according to some embodiments of the present disclosure. FIG. 1E is a schematic diagram of a partial cross-sectional structure taken along a line B1-B2 in FIG. 1A according to some embodiments of the present disclosure. It should be noted that, for clarity and brevity, some insulating layers, dielectric layers, and/or the like are omitted in FIG. 1A, FIG. 1C, and FIG. 1E.

As shown in FIG. 1A to FIG. 1E, the semiconductor structure includes an active pillar 110, a word line 120, and a bit line 140. The active pillar 110 extends in a vertical direction Z. The word line 120 extends in a first horizontal direction X and is coupled to the active pillar 120 to form a transistor. The bit line 140 extends in a second horizontal direction Y and is coupled to the active pillar 120. The second horizontal direction Y intersects the first horizontal direction X. For example, in some examples, the second horizontal direction Y may be perpendicular to the first horizontal direction X.

As shown in FIG. 1A to FIG. 1E, the word line 120 includes a first conductive pattern 121 and a second conductive pattern 122 connected to each other. The first conductive pattern 121 has a first hole H1 and a second hole H2 arranged alternately in the first horizontal direction X. The active pillar 110 is located in the first hole H1. The second conductive pattern 122 is located in the second hole H2. For example, as shown in FIG. 1B, each word line 120 may include one first conductive pattern 121 and multiple second conductive patterns 122.

The resistivity of the second conductive pattern 122 is less than the resistivity of the first conductive pattern 121. Compared with a word line formed by the same material with a relatively high resistivity, the word line 120 adopted by the semiconductor structure provided in the embodiments of the present disclosure is formed by two materials with different resistivities, thereby reducing the resistance of the word line 120.

For example, as shown in FIG. 1A to FIG. 1E, the first hole H1 may be surrounded by a first extension portion E1 and a second extension portion E2 of the first conductive pattern 121, the second hole H2 may be surrounded by the second extension portion E2 and a third extension portion E3 of the first conductive pattern 121, the first extension portion E1 extends in the first horizontal direction X, the second extension portion E2 extends in the second horizontal direction Y, and the third extension portion E3 extends in the first horizontal direction X.

For example, as shown in FIG. 1A to FIG. 1E, the width W2 of the second extension portion E2 may be greater than 1/2 of the width W1 of the first extension portion E1.

For example, as shown in FIG. 1A to FIG. 1E, the width W3 of the third extension portion E3 may be equal to the width W2 of the second extension portion E2.

In the embodiments of the present disclosure, the width W1 of the first extension portion E1 is the size of the first extension portion E1 in a horizontal direction perpendicular to the second horizontal direction Y, the width W2 of the second extension portion E2 is the size of the second extension portion E2 in a horizontal direction perpendicular to the first horizontal direction X, and the width W3 of the third extension portion E3 is the size of the third extension portion E3 in the horizontal direction perpendicular to the second horizontal direction Y. When the second horizontal direction Y is perpendicular to the first horizontal direction X, the horizontal direction perpendicular to the first horizontal direction X is the second horizontal direction Y, and the horizontal direction perpendicular to the second horizontal direction Y is the first horizontal direction X.

For example, in some examples, as shown in FIG. 1A to FIG. 1E, the width W2 of the second extension portion E2 may be less than the width W1 of the first extension portion E1, thereby helping increase the proportion of the second conductive pattern 122 with the lower resistivity in the word line 120 and further helping reduce the resistance of the word line 120. For example, in some other examples, the width W2 of the second extension portion E2 may alternatively be greater than or equal to the width W1 of the first extension portion E1.

It should be noted that the heights of the first extension portion E1, the second extension portion E2, and the third extension portion E3 are not limited in the embodiments of the present disclosure. In the embodiments of the present disclosure, the height of the first extension portion E1 is the size of the first extension portion E1 in the vertical direction Z, the height of the second extension portion E2 is the size of the second extension portion E2 in the vertical direction Z, and the height of the third extension portion E3 is the size of the third extension portion E3 in the vertical direction Z.

For example, as shown in FIG. 1A to FIG. 1E, the first hole H1 is a via, and the active pillar 110 extends through the first hole H1 in the vertical direction Z.

For example, in some examples, as shown in FIG. 1A to FIG. 1C, the second hole H2 may be a blind via. For example, referring to FIG. 1C, the first conductive pattern 121 further includes a fourth extension portion E4 underlying the second conductive pattern 122. The fourth extension portion E4, the third extension portion E3, and the second extension portion E2 enclose a recess, and the second conductive pattern 122 is located in the recess. In other words, the first conductive pattern 121 surrounds the bottom surface and the sidewalls of the second conductive pattern 122, but exposes the top surface of the second conductive pattern 122. Certainly, alternatively, the first conductive pattern 121 may surround the bottom surface and the lower portions of the sidewalls near the bottom surface of the second conductive pattern 122, but exposes the top surface and the upper portions of the sidewalls near the top surface of the second conductive pattern 122.

For example, in some other examples, as shown in FIG. 1A, FIG. 1B, and FIG. 1D, the second hole may also be a via. For example, referring to FIG. 1D, the third extension portion E3 and the second extension portion E2 of the first conductive pattern 121 surround the sidewalls of the second conductive pattern 122, but expose the top surface and bottom surface of the second conductive pattern 122.

For example, as shown in FIG. 1A to FIG. 1E, the semiconductor structure may further include a gate dielectric layer 130. The gate dielectric layer 130 is disposed in the first hole H1 and is located between the active pillar 110 and the first conductive pattern 121.

For example, as shown in FIG. 1C to FIG. 1E, the semiconductor structure may further include a data storage element 150 coupled to the transistor. For example, in some examples, the data storage element 150 may be a capacitor, and the capacitor may include a first electrode, a second electrode, and a capacitor dielectric layer (not shown) disposed between the first electrode and the second electrode. For example, the first electrode may be coupled to the active pillar 110, and the second electrodes of multiple capacitors may be formed as a common electrode. For example, in some other examples, the data storage element 150 may also be an FeRAM storage element (e.g., a ferroelectric capacitor), a PCM storage element, an MRAM storage element, or the like. That is, the semiconductor structure provided in the embodiments of the present disclosure may be formed as a DRAM, an FeRAM (ferroelectric random access memory), a PCM (phase change memory), an MRAM (magnetic random access memory), or the like.

For example, in some examples, as shown in FIG. 1C to FIG. 1E, the semiconductor structure may further include a contact pad 115, and the data storage element 150 may be coupled to a corresponding active pillar 110 through the contact pad 115. For example, in some other examples, the contact pad 115 may be omitted from the semiconductor structure.

For example, in some examples, as shown in FIG. 1C to FIG. 1E, the semiconductor structure may further include a bit line contact plug 135, and the bit line 140 may be coupled to a corresponding active pillar 110 through the bit line contact plug 135. For example, in some other examples, the bit line contact plug 135 may be omitted from the semiconductor structure.

For example, the material of the active pillar 110 may include any suitable semiconductor material, e.g., silicon, germanium, or gallium arsenide. For example, the material of the gate dielectric layer 130 may include any suitable dielectric material, e.g., silicon dioxide, silicon nitride, a high-K dielectric material, or any combination thereof. For example, the high-K dielectric material may include but is not limited to hafnium oxide (HfO₂) or zirconium oxide (ZrO₂). For example, the material of each of the bit line 140, the contact pad 115, the bit line contact plug 135, the first electrode 150, and the second electrode 160 includes any suitable conductive material, e.g., titanium nitride (TiN), tantalum nitride (TaN), tungsten, metal silicide, doped polysilicon, or any combination thereof.

For example, the word line 120 may include any suitable conductive material combination, provided that the resistivity of the material of the second conductive pattern 122 is less than that of the material of the first conductive pattern 121. For example, in some examples, the material of the first conductive pattern 121 includes titanium nitride or tantalum nitride, and the material of the second conductive pattern 122 includes molybdenum or tungsten.

For example, in some examples, the gap-fill ability (gap-fill ability) of the material of the first conductive pattern 121 is stronger than the gap-fill ability of the material of the second conductive pattern 122 (referring to related descriptions of the following embodiments of the manufacturing method). Accordingly, the process manufacturability of the word line 120 can be ensured while reducing the resistance of the word line 120.

It should be noted that for details not described in the embodiments of the semiconductor structure of the present disclosure, reference may be made to related descriptions of the following embodiments of the manufacturing method, and details are not described herein again.

In the semiconductor structure provided in the embodiments of the present disclosure, the word line includes the first conductive pattern with a larger resistivity and the second conductive pattern with a smaller resistivity, thereby helping reduce the resistance of the word line and improve device performance.

At least some embodiments of the present disclosure further provide a manufacturing method for a semiconductor structure, and the manufacturing method may be adopted to manufacture the semiconductor structure in the foregoing embodiments. FIG. 2 is a schematic flowchart of a manufacturing method for a semiconductor structure according to some embodiments of the present disclosure. For example, as shown in FIG. 2, the manufacturing method may include the following steps S100 to S400:
Step S100: providing a semiconductor substrate.
Step S200: etching the semiconductor substrate to form an active pillar extending in a vertical direction.
Step S300: forming a word line, where the word line extends in a first horizontal direction and is coupled to the active pillar, the word line includes a first conductive pattern and a second conductive pattern, the first conductive pattern has a first hole and a second hole arranged alternately in the first horizontal direction, the active pillar is located in the first hole, the second conductive pattern is located in the second hole, and the resistivity of the second conductive pattern is less than the resistivity of the first conductive pattern.
Step S400: forming a bit line, where the bit line extends in a second horizontal direction and is coupled to the active pillar, and the second horizontal direction intersects the first horizontal direction.

For example, in step S100, the material of the semiconductor substrate may include any suitable semiconductor material, e.g., silicon, germanium, or gallium arsenide.

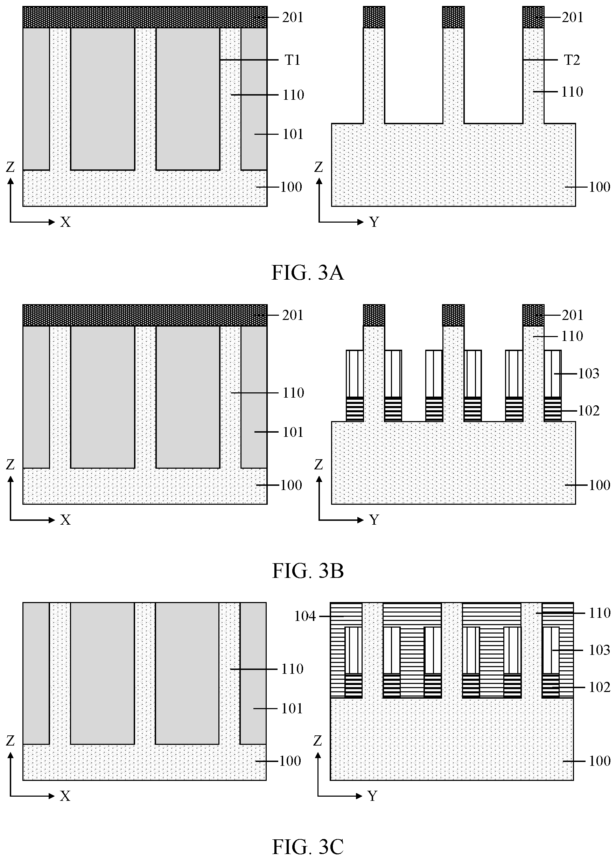

FIG. 3A to FIG. 3D are schematic diagrams of a cross-sectional structure at some stages of a manufacturing method for a semiconductor structure according to some embodiments of the present disclosure. In FIG. 3A to FIG. 3D, a sub-figure on the left corresponds to a cross-section taken along a line A1-A2 in FIG. 1A, and a sub-figure on the right corresponds to a cross-section taken along a line B1-B2 in FIG. 1A. With reference to FIG. 3A to FIG. 3D, the following describes steps S200 to S300 in the manufacturing method for a semiconductor structure provided in some embodiments of the present disclosure.

Referring to FIG. 3A, a semiconductor substrate 100 may be first etched to form a first trench T1 extending in a second horizontal direction Y, and a first isolation layer 101 may be formed in the first trench T1. Then, a patterned hard mask layer 201 is formed on the semiconductor substrate 100, and the patterned hard mask layer 201 is provided as a mask. The semiconductor substrate 100 and the first isolation layer 101 are etched to form a second trench T2 extending in a first horizontal direction X, thereby defining an active pillar 110. For example, a deposition process may be first employed to form a first isolation material layer for filling the first trench T1. Then, a chemical mechanical polishing (CMP) process or a back-etching process may be employed to remove a portion, of the first isolation material layer, outside the first trench T1. The remaining first isolation material layer located in the first trench T1 may be provided as the first isolation layer 101. The top surface of the first isolation layer 101 is flush with the top surface of the semiconductor substrate 100. For example, the material of the first isolation layer 101 may be an oxide (e.g., silicon dioxide). For example, the depth of the second trench T2 is less than the depth of the first trench T1.

Next, referring to FIG. 3B, a second isolation layer 102 and a third isolation layer 103 that are sequentially stacked may be formed on a sidewall of the second trench T2. For example, an atomic layer deposition process may be first employed to form a second isolation material layer that conformally covers the second trench T2. Then, a back-etching process may be employed to remove a portion of the second isolation material layer, and the remaining second isolation material layer located on the sidewall of the second trench T2 is provided as the second isolation layer 102. The top surface of the second isolation layer 102 is lower than the top surface of the active pillar 110. Subsequently, the atomic layer deposition process is first employed to form a third isolation material layer that conformally covers the second trench T2 and the second isolation layer 102. Then, the back-etching process is employed to remove a portion of the third isolation material layer, and the remaining third isolation material layer located on the sidewall of the second trench T2 is provided as the third isolation layer 103. The third isolation layer 103 is located on the top of the second isolation layer 102, and the top surface of the third isolation layer 103 is lower than the top surface of the active pillar 110. For example, the thickness of the third isolation material layer is substantially equal to the thickness of the second isolation layer, but is not limited thereto. For example, the material of the second isolation layer 102 is different from the material of the first isolation layer 101, and the material of the second isolation layer 102 has a higher etching selectivity ratio than the material of the first isolation layer 101. For example, the material of the second isolation layer 102 may be nitride (e.g., silicon nitride). For example, the material of the third isolation layer 103 is the same as the material of the first isolation layer 101.

Next, referring to FIG. 3C, the hard mask layer 201 may be removed, and a fourth isolation layer 104 for filling the second trench T2 may be formed. For example, a deposition process may be first employed to form a fourth isolation material layer for filling the second trench T2. Then, a chemical mechanical polishing (CMP) process or a back-etching process may be employed to remove a portion, of the fourth isolation material layer, outside the second trench T2. The remaining fourth isolation material layer located in the second trench T2 may be provided as the fourth isolation layer 104. The top surface of the fourth isolation layer 104 is flush with the top surface of the semiconductor substrate 100. For example, the material of the fourth isolation layer 104 is the same as the material of the second isolation layer 102.

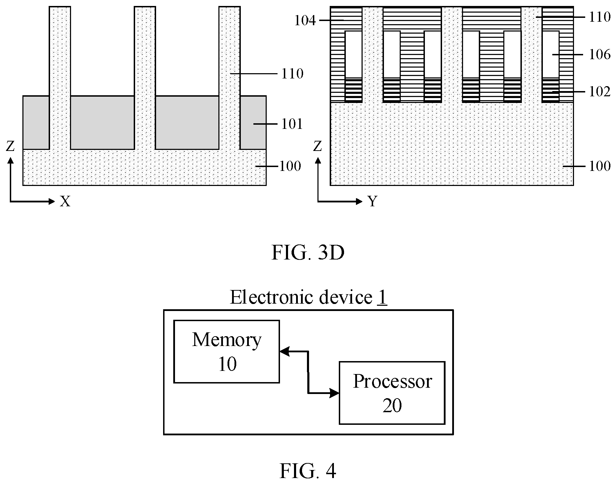

Next, referring to FIG. 3D, a selective wet etching process may be employed to remove portions of the first isolation layer 101 and the third isolation layer 103, so that an accommodation groove 106 is formed on opposite sides of the active pillar 110 in the first horizontal direction X, and the accommodation groove 106 is configured to accommodate a first extension portion E1 of a subsequently formed first conductive pattern 121. For example, as shown in FIG. 3D, the top surface of the remaining first isolation layer 101 may be lower than the bottom surface of the accommodation groove 106.

Next, in some examples, referring to FIG. 1A to FIG. 1C and FIG. 1E, a thermal oxidation process and/or an atomic layer deposition process may be first employed to form a gate dielectric layer 130. Then, the atomic layer deposition process may be employed to form a first conductive material layer, and a first conductive material fills the accommodation groove 106. Subsequently, a deposition process may be employed to form a second conductive material layer. Finally, a back-etching process is employed to remove a portion of the first conductive material layer and a portion of the second conductive material layer. The remaining first conductive material layer is provided as the first conductive pattern 121, and the remaining second conductive material layer is provided as a second conductive pattern 122, so as to obtain a word line 120. In this case, referring to FIG. 1B, the first conductive pattern 121 has a first hole H1 and a second hole H2 arranged alternately in the first horizontal direction X. The active pillar 110 is located in the first hole H1. The second conductive pattern 122 is located in the second hole H2. The first hole H1 is a via (referring to FIG. 1E), and the second hole H2 is a blind via (referring to FIG. 1C).

Alternatively, in some other examples, referring to FIG. 1A, FIG. 1B, FIG. 1D, and FIG. 1E, a thermal oxidation process and/or an atomic layer deposition process may be first employed to form a gate dielectric layer 130. Then, the atomic layer deposition process may be employed to form a first conductive material layer, and a first conductive material fills the accommodation groove 106. Subsequently, back-etching may be performed to remove a portion of the first conductive material layer, and the remaining first conductive material layer may be provided as the first conductive pattern 121. Then, a deposition process may be employed to form a second conductive material layer. Finally, a back-etching process is employed to remove a portion of the second conductive material layer, and the remaining second conductive material layer is provided as a second conductive pattern 122, so as to obtain a word line 120. In this case, referring to FIG. 1B, the first conductive pattern 121 is formed as having a first hole H1 and a second hole H2 arranged alternately in the first horizontal direction X. The active pillar 110 is located in the first hole H1. The second conductive pattern 122 is located in the second hole H2. The first hole H1 is a via (referring to FIG. 1E), and the second hole H2 is also a via (referring to FIG. 1D).

For example, to better fill the accommodation groove 106, a conductive material with a relatively strong gap-fill ability (gap-fill ability) may be selected for the first conductive material layer (corresponding to the first conductive pattern 121). To reduce the resistance of the word line 120, a conductive material with a relatively low resistivity may be selected for the second conductive material layer (corresponding to the second conductive pattern 122). For example, in some examples, the material of the first conductive pattern 121 includes titanium nitride or tantalum nitride, and the material of the second conductive pattern 122 includes molybdenum or tungsten. Compared with a word line formed by the same material with a relatively strong gap-fill ability and a relatively high resistivity, the word line 120 adopted by the semiconductor structure provided in the embodiments of the present disclosure is formed by one material with a relatively strong gap-fill ability (which may have a relatively high resistivity) and another material with a relatively low resistivity (which may have a relatively weak gap-fill ability), thereby reducing the resistance of the word line 120 and increasing a selectable range of materials for the word line 120.

For example, as shown in FIG. 1A to FIG. 1E, the first hole H1 may be surrounded by a first extension portion E1 and a second extension portion E2 of the first conductive pattern 121, the second hole H2 may be surrounded by the second extension portion E2 and a third extension portion E3 of the first conductive pattern 121, the first extension portion E1 extends in the first horizontal direction X, the second extension portion E2 extends in the second horizontal direction Y, and the third extension portion E3 extends in the first horizontal direction X. It may be understood that because the atomic layer deposition process is employed to form the first conductive material layer (corresponding to the first conductive pattern 121), the width W3 of the third extension portion E3 is usually equal to the width W2 of the second extension portion E2. In addition, the actual deposition rate of the second extension portion E2 in the accommodation groove 106 is approximately twice that of the first conductive material layer. To ensure that the accommodation groove 106 is filled with the first conductive material layer, the width W2 of the second extension portion E2 is usually greater than 1/2 of the width W1 of the first extension portion E1.

In the embodiments of the present disclosure, the width W1 of the first extension portion E1 is the size of the first extension portion E1 in a horizontal direction perpendicular to the second horizontal direction Y, the width W2 of the second extension portion E2 is the size of the second extension portion E2 in a horizontal direction perpendicular to the first horizontal direction X, and the width W3 of the third extension portion E3 is the size of the third extension portion E3 in the horizontal direction perpendicular to the second horizontal direction Y. When the second horizontal direction Y is perpendicular to the first horizontal direction X, the horizontal direction perpendicular to the first horizontal direction X is the second horizontal direction Y, and the horizontal direction perpendicular to the second horizontal direction Y is the first horizontal direction X.

For example, the material of the gate dielectric layer 130 may include any suitable dielectric material, e.g., silicon dioxide, silicon nitride, a high-K dielectric material, or any combination thereof.

For example, in some examples, in step S400, the semiconductor substrate 100 may be thinned from the back, until one end of the active pillar 110 near the back of the semiconductor substrate 100 is exposed, and then a bit line 140 coupled to the active pillar 110 is formed on the back of the semiconductor substrate 100. For example, in some other examples, in step S400, heavy doping may be performed from the front side on portions of the semiconductor substrate 100 that are located beneath multiple active pillars 110 arranged in the second horizontal direction, thereby forming a bit line 140. It should be noted that in the embodiments of the present disclosure, a method for forming a bit line in step S400 is not limited. For the method for forming a bit line, reference may be made to a common method in the prior art.

For example, in some embodiments, based on the steps S100 to S400, the manufacturing method may further include the following step S500.

In step S500, a data storage element is formed, where the data storage element is coupled to an active pillar.

For example, referring to FIG. 1C to FIG. 1E, a data storage element 150 coupled to the active pillar 110 may be formed. For example, in some examples, the data storage element 150 may be a capacitor, and the capacitor may include a first electrode, a second electrode, and a capacitor dielectric layer (not shown) disposed between the first electrode and the second electrode. For example, the first electrode may be coupled to the active pillar 110, and the second electrodes of multiple capacitors may be formed as a common electrode. For example, in some other examples, the data storage element 150 may also be an FeRAM storage element (e.g., a ferroelectric capacitor), a PCM storage element, an MRAM storage element, or the like. That is, the semiconductor structure provided in the embodiments of the present disclosure may be formed as a DRAM, an FeRAM (ferroelectric random access memory), a PCM (phase change memory), an MRAM (magnetic random access memory), or the like. It should be noted that in the embodiments of the present disclosure, a method for forming a data storage element in step S500 is not limited. For the method for forming a data storage element, reference may be made to a common method in the prior art.

For example, in some embodiments, referring to FIG. 1C to FIG. 1E, the manufacturing method may further include the following step: forming a contact pad 115, where the contact pad 115 is configured to be electrically connected to the active pillar 110 and the data storage element 150. For example, the contact pad 115 may include any suitable conductive material, e.g., titanium nitride (TiN), tantalum nitride (TaN), tungsten, metal silicide, doped polysilicon, or any combination thereof.

For example, in some embodiments, referring to FIG. 1C to FIG. 1E, the manufacturing method may further include the following step: forming a bit line contact plug 135, where the bit line contact plug 135 is configured to be electrically connected to the active pillar 110 and the bit line 140. For example, the bit line contact plug 135 may include any suitable conductive material, e.g., titanium nitride (TiN), tantalum nitride (TaN), tungsten, metal silicide, doped polysilicon, or any combination thereof.

For example, the manufacturing method may further include the steps of forming a source region and a drain region in the active pillar 110, and the like. For implementations of these steps, reference may be made to a common method in the prior art, which is not limited herein.

It should be noted that, for details not described in the embodiments of the manufacturing method of the present disclosure, reference may be made to related descriptions of the embodiments of the foregoing semiconductor structure. Details are not described herein again.

For technical effects and other details of the manufacturing method provided in the embodiments of the present disclosure, reference may be made to related descriptions of the embodiments of the foregoing semiconductor structure. Details are not described herein again.

At least some embodiments of the present disclosure further provide an electronic device. FIG. 4 is a schematic block diagram of a structure of an electronic device according to some embodiments of the present disclosure. As shown in FIG. 4, the electronic device 1 includes a processor 20 and a memory 10 that are coupled to each other. The memory 10 includes the semiconductor structure provided in any one of the foregoing embodiments.

For example, the processor 20 may include but is not limited to a central processing unit (CPU), a graphics processing unit (GPU), and the like. The memory 10 may be configured to store data to be processed by the processor 20 and/or data processed by the processor.

For example, the electronic device 1 includes but is not limited to a mobile phone, a tablet computer, a smart wristband, a wearable electronic device, a virtual reality device, an augmented reality device, an on-board device, a server, and a workstation.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A semiconductor structure, comprising:
an active pillar (110), extending in a vertical direction (Z);
a word line (120), extending in a first horizontal direction (X) and coupled to the active pillar to form a transistor; and
a bit line (140), extending in a second horizontal direction (Y) and coupled to the active pillar, the second horizontal direction intersecting the first horizontal direction;
the word line comprising a first conductive pattern (121) and a second conductive pattern (122) connected to each other, the first conductive pattern having a first hole (H1) and a second hole (H2) arranged alternately in the first horizontal direction, the active pillar being located in the first hole, the second conductive pattern being located in the second hole, and a resistivity of the second conductive pattern being less than a resistivity of the first conductive pattern.

2. The semiconductor structure according to claim 1, wherein the first hole is surrounded by a first extension portion (E1) and a second extension portion (E2) of the first conductive pattern, the first extension portion extends in the first horizontal direction, the second extension portion extends in the second horizontal direction, and a width (W2) of the second extension portion is greater than 1/2 of a width (W1) of the first extension portion.

3. The semiconductor structure according to claim 2, wherein the width of the second extension portion is less than the width of the first extension portion.

4. The semiconductor structure according to claim 2 or 3, wherein the second hole is surrounded by the second extension portion and a third extension portion (E3) of the first conductive pattern, the third extension portion extends in the first horizontal direction, and a width (W3) of the third extension portion is equal to the width of the second extension portion.

5. The semiconductor structure according to any one of claims 1 to 4, wherein the first hole is a via, and the second hole is a via.

6. The semiconductor structure according to any one of claims 1 to 4, wherein the first hole is a via, and the second hole is a blind via.

7. The semiconductor structure according to any one of claims 1 to 6, wherein a gap-fill ability of a material of the first conductive pattern is stronger than a gap-fill ability of a material of the second conductive pattern.

8. The semiconductor structure according to any one of claims 1 to 7, wherein the material of the first conductive pattern comprises titanium nitride or tantalum nitride, and the material of the second conductive pattern comprises molybdenum or tungsten.

9. The semiconductor structure according to any one of claims 1 to 8, further comprising:
a data storage element, coupled to the transistor.

10. A manufacturing method for a semiconductor structure, comprising:
providing a semiconductor substrate (100);
etching the semiconductor substrate to form an active pillar (110) extending in a vertical direction (Z);
forming a word line (120), the word line extending in a first horizontal direction (X) and coupled to the active pillar; and
forming a bit line (140), the bit line extending in a second horizontal direction (Y) and coupled to the active pillar, and the second horizontal direction intersecting the first horizontal direction;
the word line comprising a first conductive pattern (121) and a second conductive pattern (122), the first conductive pattern having a first hole (H1) and a second hole (H2) arranged alternately in the first horizontal direction, the active pillar being located in the first hole, the second conductive pattern being located in the second hole, and a resistivity of the second conductive pattern being less than a resistivity of the first conductive pattern.

11. The manufacturing method according to claim 10, wherein the first hole is surrounded by a first extension portion (E1) and a second extension portion (E2) of the first conductive pattern, the first extension portion extends in the first horizontal direction, the second extension portion extends in the second horizontal direction, and a width (W2) of the second extension portion is greater than 1/2 of a width (W1) of the first extension portion.

12. The manufacturing method according to claim 11, wherein the width of the second extension portion is less than the width of the first extension portion.

13. The manufacturing method according to claim 11 or 12, wherein the second hole is surrounded by the second extension portion and a third extension portion (E3) of the first conductive pattern, the third extension portion extends in the first horizontal direction, and a width (W3) of the third extension portion is equal to the width of the second extension portion.

14. The manufacturing method according to any one of claims 10 to 13, wherein the first hole is a via, and the second hole is a via.

15. The manufacturing method according to any one of claims 10 to 13, wherein the first hole is a via, and the second hole is a blind via.

16. The manufacturing method according to any one of claims 10 to 15, wherein a gap-fill ability of a material of the first conductive pattern is stronger than a gap-fill ability of a material of the second conductive pattern.

17. The manufacturing method according to any one of claims 10 to 16, wherein the material of the first conductive pattern comprises titanium nitride or tantalum nitride, and the material of the second conductive pattern comprises molybdenum or tungsten.

18. The manufacturing method according to any one of claims 10 to 17, further comprising:
forming a data storage element coupled to the active pillar.

19. An electronic device (1), comprising:
a processor (20); and
a memory (10), the memory coupled to the processor, and the memory comprising the semiconductor structure according to any one of claims 1 to 9.
